# EUROPEAN PATENT APPLICATION

(11) **EP 4 637 300 A1**
(43) Date of publication of application: **22.10.2025**
(21) Application number: 25158990.9
(22) Date of filing: 20.02.2025
(51) Int. Cl.: H10F 19/90, H10F 71/00, H01L 21/677, H01L 21/68

(54) **ALIGNING DEVICE AND TABBING APPARATUS INCLUDING THE SAME**

(30) Priority: 22.02.2024 KR 20240025911
(71) Applicant: Hanwha Solutions Corporation, Jung-gu Seoul 04541 (KR)
(72) Inventor: JUNG, Min Kyo, 04541 Seoul (KR); BAEK, Dong Heon, 04541 Seoul (KR); CHUNG, Dong Jin, 04541 Seoul (KR)
(74) Representative: Mooser, Sebastian Thomas

(57) **Abstract**

The present disclosure relates to an aligning device and a tabbing apparatus including the same, and the aligning device includes a rail unit, a plurality of shuttles movably installed on the rail unit, and an adjustment unit connected to the shuttle and configured to adjust a distance between a pair of neighboring shuttles.

## Description

### BACKGROUND

### 1. Field of the Invention

The present disclosure relates to an aligning device and a tabbing apparatus including the same, and more specifically, to an aligning device and a tabbing apparatus including the same, which allow a distance between neighboring solar cells to be adjusted in a tabbing process.

### 2. Discussion of Related Art

In general, a solar cell is formed by arranging p-n junction diodes on a substrate. When a solar cell is irradiated with sunlight, an exciton, which is an electron-hole pair, is generated, and as the exciton separates, the electron moves to an n layer, the hole moves to a p layer, and thus photovoltaic power is generated at a p-n junction.

In general, since the maximum voltage generated by a single unit solar cell is only about 0.5 V, multiple solar cells need to be connected in series to be used. A module formed by connecting multiple unit solar cells in this way is called a solar cell module.

A tabbing process is a process of forming a single solar cell module by arranging wires on a plurality of solar cells and electrically connecting the plurality of solar cells.

The background technology of the present disclosure is disclosed in Korean Patent Registration No. 10-1058399 (registered on August 16, 2011, entitled "Tabber-stringer and tabbing-stringing method).

### SUMMARY OF THE INVENTION

The present disclosure is directed to providing an aligning device and a tabbing apparatus including the same, which allow a distance between neighboring solar cells to be adjusted in a tabbing process.

According to an aspect of the present disclosure, there is provided an aligning device including a rail unit, a plurality of shuttles movably installed on the rail unit, and an adjustment unit connected to the shuttles and configured to adjust a distance between a pair of neighboring shuttles.

The shuttles may include a first shuttle and a second shuttle arranged in a first direction, and the second shuttle may move in the first direction along with the first shuttle as the first shuttle moves in the first direction.

The adjustment unit may include a first adjustment member connected to the first shuttle and configured to move the first shuttle in the first direction or a direction opposite to the first direction and a second adjustment member connected to the second shuttle and configured to selectively allow the second shuttle to move in the direction opposite to the first direction.

The first adjustment member may include an actuator configured to generate a driving force, a conversion member connected to the actuator and configured to convert the driving force of the actuator into linear movement, and a transmission member connected to the conversion member and the first shuttle and configured to move the first shuttle in conjunction with the linear movement of the conversion member.

The conversion member may include a first conversion member that receives the driving force from the actuator to rotate and a second conversion member connected to the first conversion member and configured to move in the first direction or the direction opposite to the first direction according to a rotational direction of the first conversion member.

The first conversion member may be disposed parallel to the first direction.

The second adjustment member may include a first connection member disposed between the first shuttle and the second shuttle and selectively connecting the first shuttle and the second shuttle.

The first connection member may include a first connection body fixed to the second shuttle and disposed to face the first shuttle and a first electromagnet provided in the first connection body and configured to receive external power and generate a magnetic force, and the first connection body may be fixed to the first shuttle by the magnetic force generated by the first electromagnet.

The first connection body may extend from the second shuttle in the direction opposite to the first direction.

The first connection body may come into contact with the first shuttle as the first shuttle moves in the first direction.

The second shuttle may be provided as a plurality of second shuttles, and the plurality of second shuttles may be arranged in the first direction.

The second adjustment member may include a second connection member disposed between a pair of neighboring second shuttles and selectively connecting the pair of neighboring second shuttles.

The second connection member may include a second connection body fixed to one of the pair of neighboring second shuttles and a second electromagnet provided in the second connection body and configured to receive external power and generate a magnetic force, and the second connection body may be fixed to the other of the pair of neighboring second shuttles by the magnetic force generated by the second electromagnet.

The adjustment unit may further include a shuttle adjustment member disposed between the first shuttle and the first adjustment member and configured to selectively allow the first shuttle to move in the direction opposite to the first direction.

The shuttle adjustment member may include a shuttle connection body fixed to the first shuttle and disposed to face the first adjustment member and a shuttle electromagnet provided in the shuttle connection body and configured to receive external power and generate a magnetic force, and the shuttle connection body may be fixed to the first adjustment member by the magnetic force generated by the shuttle electromagnet.

According to another aspect of the present disclosure, there is provided a tabbing apparatus including a transport line configured to transport a plurality of solar cells, a bonding device configured to bond the solar cell transported by the transport line and a wire seated on the solar cell, and an aligning device configured to adjust a distance between the plurality of solar cells transported by the transport line, wherein the aligning device includes a rail unit, a plurality of shuttles movably installed on the rail unit and selectively connected to the solar cells that are different from each other, and an adjustment unit connected to the shuttles and configured to adjust a distance between a pair of neighboring shuttles.

### BRIEF DESCRIPTION OF THE DRAWINGS

The above and other objects, features and advantages of the present disclosure will become more apparent to those of ordinary skill in the art by describing exemplary embodiments thereof in detail with reference to the accompanying drawings, in which:
FIG. 1 is a schematic side view illustrating a configuration of a tabbing apparatus according to one embodiment of the present disclosure;
FIG. 2 is a schematic cross-sectional view illustrating the configuration of the tabbing apparatus according to one embodiment of the present disclosure;
FIG. 3 is a schematic perspective view illustrating a configuration of an aligning device according to one embodiment of the present disclosure;
FIG. 4 is a schematic side view illustrating the configuration of the aligning device according to one embodiment of the present disclosure;
FIG. 5 is a schematic perspective view illustrating a configuration of a first adjustment member according to one embodiment of the present disclosure;
FIG. 6 is a schematic enlarged view illustrating a configuration of a second adjustment member according to one embodiment of the present disclosure;
FIGS. 7 to 10 are schematic views illustrating an operation process of the aligning device according to one embodiment of the present disclosure;
FIG. 11 is a schematic perspective view illustrating a configuration of an aligning device according to another embodiment of the present disclosure; and
FIG. 12 is a schematic side view illustrating a configuration of a shuttle adjustment member according to another embodiment of the present disclosure.

### DETAILED DESCRIPTION OF EXEMPLARY EMBODIMENTS

Hereinafter, embodiments of the present disclosure will be described, in detail, with reference to the accompanying drawings. Prior to this, terms or words used in this specification and claims should not be interpreted as limited to their usual or dictionary meanings and should be interpreted as meanings and concepts that conform to the technical idea of the present disclosure based on the principle that the inventor can appropriately define the concepts of the terms in order to describe his or her own invention in the best way. The embodiments described in this specification and the configurations shown in the drawings are only some embodiments of the present disclosure and do not represent all of the technical ideas of the present disclosure. Accordingly, it should be understood that there may be various equivalents and modifications that can replace them at the time of filing this application. In addition, when used in the present specification, "comprise" and "include" and/or "comprising" and "including" specify the presence of the stated shapes, numbers, steps, operations, members, elements, and/or groups thereof and do not preclude the presence or addition of one or more other shapes, numbers, operations, members, elements, and/or groups thereof. In addition, when embodiments of the present disclosure are described, "may" and "may be" may include "one or more embodiments of the present disclosure."

In addition, to facilitate understanding of the invention, the accompanying drawings are not drawn to scale, and the dimensions of some components may be shown in an exaggerated manner. In addition, the same reference numbers may denote the same components in different embodiments.

When two objects of comparison are "the same", it means that they are "substantially the same." Accordingly, "substantially the same" may include a deviation that is considered low in the art, for example, a deviation within 5%. In addition, uniformity of a parameter over a given region may mean uniformity from the viewpoint of an average.

Although "first," "second," etc. are used to describe various components, these components are not limited by these terms. These terms are used only to distinguish one component from another, and unless otherwise stated, it is obvious that a first component may be a second component.

Throughout the specification, unless otherwise stated, each element may be singular or plural.

When any component is disposed "above (or below)" or "on (or under)" a component, it may mean not only that any component is disposed in contact with an upper surface (or lower surface) of the component, but also that other components may be interposed between the component and any component disposed on (or under) the component.

In addition, when a certain component is described as being "connected," "coupled," or "joined" to another component, the components may be directly connected or joined, but it should be understood that another component may be "interposed" between the components, or the components may be "connected," "coupled," or "joined" through the other component. In addition, when a first component is described as being "electrically coupled to" a second component, this includes not only a case in which the first component is "directly coupled" to the second component, but also a case in which the first component is "coupled" to the second component with a third component interposed therebetween.

When referring to "A and/or B" throughout the specification, this means A, B or A and B unless otherwise specified. In other words, the term "and/or" includes all or any combination of the plurality of listed items. When referring to "C to D," this means C or more and D or less unless otherwise specified.

When phrases such as "at least one of A, B, and C, "at least one of A, B, or C," "at least one selected from a group of A, B, and C," and "at least one selected from among A, B, and C" are used to designate a list of elements A, B, and C, the phrase may refer to any and all suitable combinations thereof.

The term "use" may be considered synonymous with the term "utilize." As used herein, the terms "substantially," "about," and similar terms are used as terms of approximation and not as terms of degree and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be named a second element, component, region, layer, or section without departing from the teachings of example embodiments.

Spatially relative terms, such as "beneath," "below," "lower," "above," "upper," and the like, may be used herein for ease of description to describe a relationship of one element or feature to (an)other element(s) or feature(s) as illustrated in the drawings. It will be understood that the spatially relative terms are intended to encompass different orientations of the device in use or operation in addition to the orientations depicted in the drawings. For example, if a device in the drawings is turned over, elements described as "below" or "beneath" other elements would then be understood to be "above" or "over" the other elements. Thus, the term "below" may encompass both an orientation of above and below.

The terminology used herein is intended to describe embodiments of the present disclosure and is not intended to limit the present disclosure.

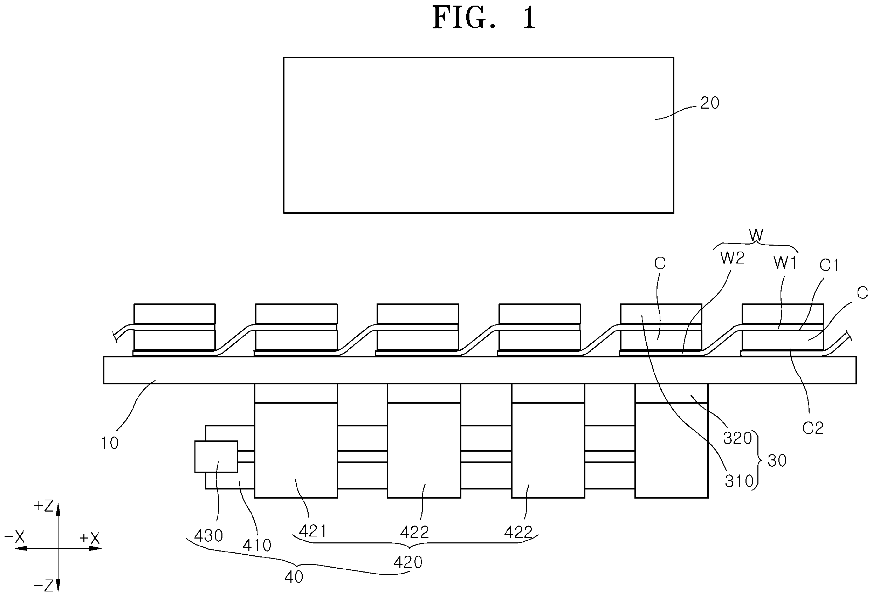

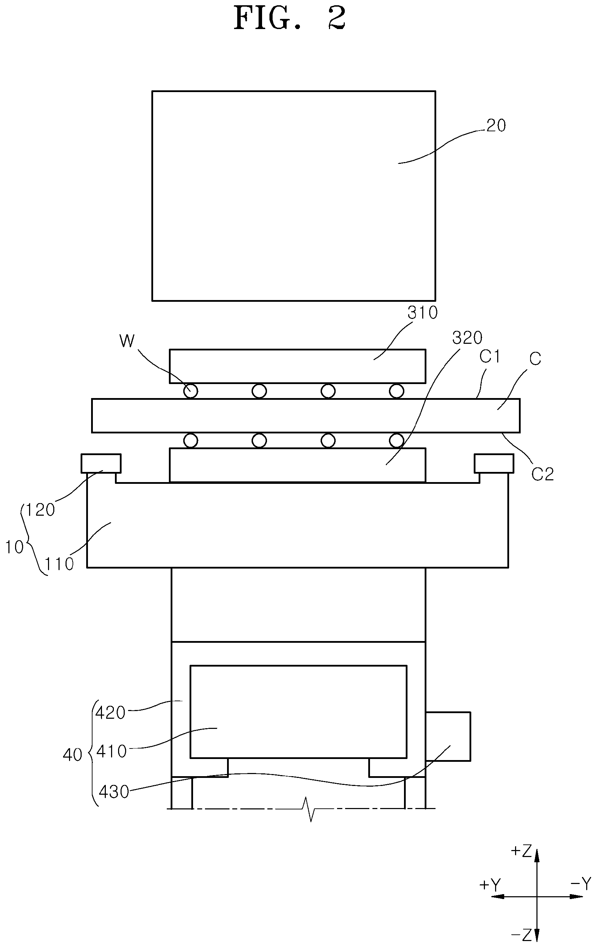

FIG. 1 is a schematic side view illustrating a configuration of a tabbing apparatus according to one embodiment of the present disclosure, and FIG. 2 is a schematic cross-sectional view illustrating the configuration of the tabbing apparatus according to one embodiment of the present disclosure.

Referring to FIGS. 1 and 2, the tabbing apparatus is an apparatus for connecting solar cells C to wires W to form a solar cell module and may include a transport line 10, a bonding device 20, a pressing device 30, and an aligning device 40.

The transport line 10 may transport the solar cell C and the wire W. More specifically, the transport line 10 may serve as a component for continuously transporting the solar cell C and the wire W in a first direction.

The solar cell C has a semiconductor junction area having a p-n junction surface, and when energy with a predetermined magnitude or more is radiated, an electromotive force may be generated to convert light energy into electrical energy. A material of a semiconductor included in the solar cell C is not particularly limited, and silicon (single crystalline, polycrystalline, or amorphous silicon), gallium arsenide, cadmium tellurium, cadmium sulfide, indium phosphide, copper indium gallium selenide (CIGS), an organic dye, or a mixture thereof may be used.

The solar cell C may be provided as a plurality of solar cells. The plurality of solar cells C may be arranged in the first direction. The first direction may be one of the directions parallel to the solar cell C. For example, the first direction may be a +X-axis direction based on FIG. 1.

The solar cell C may include a first surface C1 and a second surface C2 which are opposite to each other and parallel to the first direction. The first surface C1 and the second surface C2 may serve as a positive electrode and a negative electrode of the solar cell C, respectively. The first surface C1 and the second surface C2 may be spaced apart from each other in a second direction. Here, the second direction may be a direction intersecting the first direction and may be a +Z-axis direction based on FIG. 1.

The wire W may serve as a conductor for electrically connecting a plurality of solar cells C. The wire W may electrically connect a pair of solar cells C disposed adjacent to each other in a solar cell module.

A longitudinal direction of the wire W may extend in the first direction. Both sides of the wire W may be disposed to face a pair of neighboring solar cells C in the first direction, respectively. For example, the wire W may include a first portion W1 facing the first surface C1 of one of the neighboring solar cells C, and a second portion W2 facing the second surface C2 of the other.

The wire W may be provided as a plurality of wires. The plurality of wires W may be individually disposed between neighboring solar cells C.

One solar cell C may have a plurality of wires W disposed parallel to each other in a third direction. Here, the third direction may be a direction intersecting the first direction and the second direction and may be a +Y-axis direction based on FIG. 1.

The wire W may be electrically connected to the solar cell C through a soldering process. In this case, the solar cell C and the wire W may be transported in the first direction by the transport line 10 in a state in which surfaces are coated with a flux. Alternatively, the wire W may be electrically connected to the solar cell C through an electrically conductive adhesive (ECA) curing process. In this case, the solar cell C and the wire W may be transported in the first direction by the transport line 10 in a state in which the surfaces are coated with an ECA.

The transport line 10 according to the present embodiment may include a transport body 110 and a transport member 120.

The transport body 110 may be disposed to face the second surface C2 of the solar cell C.

The transport body 110 according to the present embodiment may be installed to reciprocate in a direction parallel to the first direction at a position spaced apart from the second surface C2 of the solar cell C. In this case, the transport body 110 may be installed to reciprocate in a direction parallel to the second direction at the position spaced apart from the second surface C2 of the solar cell C. The transport body 110 may be connected to a power device (not illustrated) such as a motor, a cylinder, or the like and may receive a driving force from the power device and move in the direction parallel to the first direction and the second direction.

The transport body 110 may circulate along a set path. For example, the transport body 110 may sequentially move in the second direction, the first direction, a direction opposite to the second direction, and a direction opposite to the first direction.

The transport member 120 may be connected to the transport body 110 and may move the solar cell C and the wire W in the first direction in conjunction with the movement of the transport body 110.

The transport member 120 according to the present embodiment may extend from the transport body 110 toward the second surface C2 of the solar cell C. A longitudinal direction of the transport member 120 may extend in the direction parallel to the first direction. Accordingly, the transport member 120 may be disposed to simultaneously face the second surfaces C2 of the plurality of solar cells C arranged in the first direction.

The transport member 120 may come into contact with the second surface C2 as the transport body 110 moves in the second direction. Thereafter, the transport member 120 may move the solar cell C and the wire W in the first direction while in contact with the second surface C2 of the solar cell C as the transport body 110 moves in the first direction. Thereafter, the transport member 120 may be separated from the second surface C2 as the transport body 110 moves in the direction opposite to the second direction. When the transport member 120 moves in the direction opposite to the second direction, the solar cell C may be seated on the pressing device 30 or a separate support (not illustrated) to maintain a state of being spaced apart from the transport member 120. Thereafter, as the transport body 110 moves in the direction opposite to the first direction, the transport member 120 may be returned to an initial position. Accordingly, the solar cell C and the wire W may move a movement distance of the transport member 120 in the first direction step in a stepwise manner at set time intervals.

The bonding device 20 may bond the solar cell C and the wire W which are transported by the transport line 10. For example, the bonding device 20 may include various types of heating devices for heating the solar cell C and the wire W which are transported by the transport line 10 to melt a solder layer of the wire W or curing an ECA with which a connecting portion of the solar cell C and the wire W is coated.

The bonding device 20 may operate alternately with the transport line 10. For example, the bonding device 20 may heat the solar cell C and the wire W when the transport member 120 is separated from the solar cell C and does not transport the solar cell C and the wire W. In addition, the bonding device 20 may stop the heating operation for the solar cell C and the wire W when the transport member 120 is in contact with the solar cell C and transports the solar cell C and the wire W. However, the bonding device 20 is not limited to such an operation and may perform an operation independent of the transport line 10.

The pressing device 30 may serve as a component for fixing a relative position of the wire W with respect to the solar cell C during the bonding process of the solar cell C and the wire W.

The pressing device 30 according to the present embodiment may include a first pressing member 310 and a second pressing member 320.

The first pressing member 310 according to the present embodiment may be disposed to face the first surface C1 of the solar cell C. The first pressing member 310 may come into contact with the first portion W1 of the wire W, which faces the first surface C1, and may press the first portion W1 toward the first surface C1.

The first pressing member 310 may be provided as a plurality of first pressing members. Each first pressing member 310 may be disposed to individually face the first surface C1 of a different solar cell C.

The first pressing member 310 may move in the first direction along with the solar cell C when the solar cell C is moved in the first direction by the transport line 10.

The second pressing member 320 may be disposed to face the second surface C2 of the solar cell C. The second pressing member 320 may come into contact with the second portion W2 of the wire W, which faces the second surface C2, and may press the second portion W2 toward the second surface C2.

The second pressing member 320 may selectively press the second portion W2 of the wire W. That is, a part of the second pressing member 320, which faces the second portion W2 of the wire W, may be provided to be brought into contact with or separated from the second portion W2 of the wire W. During the operation of the bonding device 20, the second pressing member 320 may be brought into contact with the second portion W2 of the wire W and may firmly bring the second portion W2 into close contact with the second surface C2. The second pressing member 320 may be separated from the second portion W2 when the solar cell C and the wire W are moved in the first direction by the transport line 10.

The second pressing member 320 may movably support the second surface C2 of the solar cell C. For example, the remaining area of the second pressing member 320 excluding the area in contact with the second portion W2 of the wire W may maintain a state of being in contact with the second surface C2 of the solar cell C. Accordingly, the second pressing member 320 may be positionally fixed without moving along with the solar cell C when the solar cell C is moved in the first direction by the transport line 10.

The second pressing member 320 may be provided as a plurality of second pressing members. Each second pressing member 320 may be disposed to individually face the second surface C2 of a different solar cell C. The number of second pressing members 320 may be less than the number of first pressing members 310. The number of second pressing members 320 is not limited to the number illustrated in FIG. 1 and may be designed to vary depending on a movement distance of the transport member 120 in the first direction or the like.

The aligning device 40 may adjust a distance between a plurality of solar cells C transported by the transport line 10. Accordingly, the aligning device 40 may separate a continuous assembly of the solar cells C and the wires W into solar cell string units formed of a set number of solar cells C.

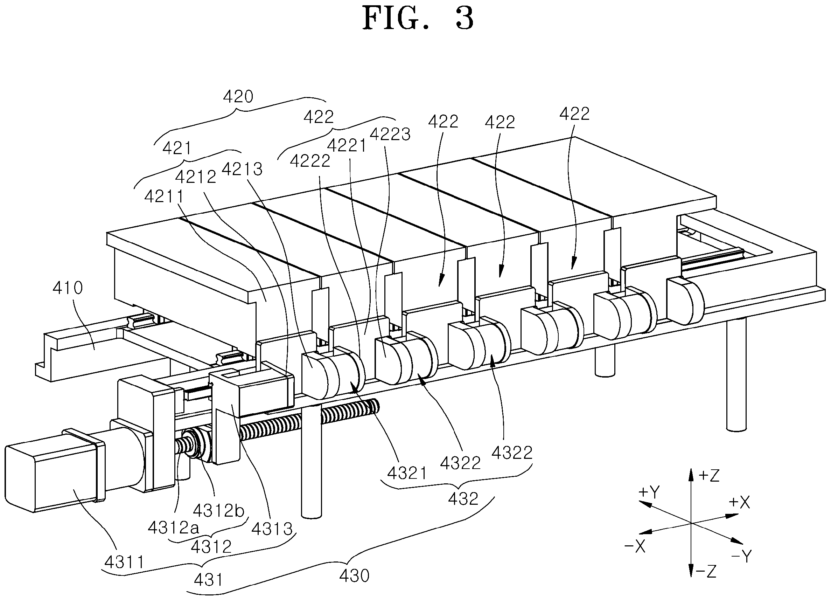

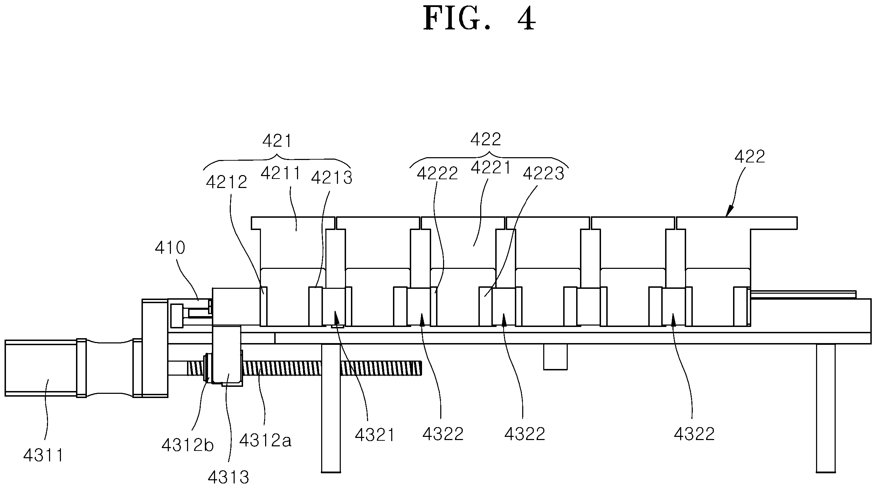

FIG. 3 is a schematic perspective view illustrating a configuration of an aligning device according to one embodiment of the present disclosure, and FIG. 4 is a schematic side view illustrating the configuration of the aligning device according to one embodiment of the present disclosure.

Referring to FIGS. 1 to 4, the aligning device 40 according to the present embodiment may include a rail unit 410, a shuttle 420, and an adjustment unit 430.

The rail unit 410 may serve as a component for guiding the movement of the shuttle 420 to be described below. The rail unit 410 according to the present embodiment may be disposed to face the second surface C2 of the solar cell C at a predetermined distance. A longitudinal direction of the rail unit 410 may extend in the direction parallel to the first direction. The length of the rail unit 410 may be longer than the total length of a plurality of second pressing members 320 parallel to the first direction. The rail unit 410 may be fixed to the ground or a separate frame (not illustrated). A specific shape of the rail unit 410 is not limited to the shape illustrated in FIG. 3 and may be designed to have various shapes which can guide the movement of the shuttle 420.

The shuttle 420 may be movably installed on the rail unit 410. The shuttle 420 may move along the rail unit 410 in the first direction or in the direction opposite to the first direction.

The shuttle 420 may be provided as a plurality of shuttles. Each shuttle 420 may individually movably support a different second pressing member 320. The number of shuttles 420 may be formed to correspond to the number of second pressing members 320. However, the shuttle 420 is not limited thereto and may directly movably support the second surface C2 of the solar cell C independently of the transport member 120 and the second pressing member 320.

The plurality of shuttles 420 according to the present embodiment may include a first shuttle 421 and a second shuttle 422.

The first shuttle 421 and the second shuttle 422 may be sequentially arranged in the first direction. That is, the second shuttle 422 may be disposed at a position spaced apart from the first shuttle 421 in the first direction. Accordingly, when the first shuttle 421 moves in the first direction, the second shuttle 422 may come into contact with the first shuttle 421 and move in the first direction along with the first shuttle 421. When the first shuttle 421 moves in the direction opposite to the first direction in a state in which a separate external force does not act between the first shuttle 421 and the second shuttle 422, the first shuttle 421 may be separated from the second shuttle 422, and the second shuttle 422 may not move in the direction opposite to the first direction along with the first shuttle 421.

The second shuttle 422 may be provided as one or more second shuttles. Hereinafter, an example in which the second shuttle 422 is provided as a plurality of second shuttles will be described, but the second shuttle 422 is not limited thereto and may be formed as one second shuttle.

The plurality of second shuttles 422 may be arranged in the first direction from the first shuttle 421.

When one second shuttle 422 moves in the first direction, the plurality of second shuttles 422 arranged in the first direction from the corresponding second shuttle 422 may come into contact with each other and move in the first direction.

When one second shuttle 422 moves in the second direction in a state in which a separate external force does not act between neighboring second shuttles 422, the plurality of second shuttles 422 arranged in the first direction from the corresponding second shuttle 422 may be separated from the corresponding second shuttle 422 and may not move in the first direction.

The first shuttle 421 according to the present embodiment may include a first shuttle body 4211, a main bracket 4212, and a first connection bracket 4213.

The first shuttle body 4211 may form an approximate exterior of the first shuttle 421 and entirely support the main bracket 4212 and the first connection bracket 4213. A specific shape of the first shuttle body 4211 is not limited to the shape illustrated in FIGS. 3 and 4 and various design changes are possible within the range of shapes which can reciprocate in the first direction or the direction opposite to the first direction on the rail unit 410.

The main bracket 4212 and the first connection bracket 4213 may extend from the first shuttle body 4211. The main bracket 4212 and the first connection bracket 4213 may serve as components for providing a connection portion of the first shuttle 421 to the adjustment unit 430 to be described below.

The main bracket 4212 and the first connection bracket 4213 according to the present embodiment may extend from an outer surface of the first shuttle body 4211 in a direction parallel to the third direction. The main bracket 4212 and the first connection bracket 4213 may be sequentially disposed in the first direction. That is, the first connection bracket 4213 may be disposed at a position spaced a predetermined distance from the main bracket 4212 in the first direction. The main bracket 4212 and the first connection bracket 4213 may be formed of a ferromagnetic material such as iron. Specific shapes of the main bracket 4212 and the first connection bracket 4213 are not limited to the shapes illustrated in FIGS. 3 and 4 and various design changes are possible within the range of shapes which extend from the first shuttle body 4211 and are disposed to be spaced apart from the first shuttle body 4211 in the first direction.

The second shuttle 422 according to the present embodiment may include a second shuttle body 4221, a second connection bracket 4222, and a third connection bracket 4223.

The second shuttle body 4221 may form an approximate exterior of the second shuttle 422 and entirely support the second connection bracket 4222 and the third connection bracket 4223. The second shuttle body 4221 may be disposed at a position spaced apart from the first shuttle body 4211 in the first direction. A specific shape of the second shuttle body 4221 is not limited to the shape illustrated in FIGS. 3 and 4 and various design changes are possible within the range of shapes which can reciprocate in the first direction or the direction opposite to the first direction on the rail unit 410.

The second connection bracket 4222 and the third connection bracket 4223 may extend from the second shuttle body 4221. The second connection bracket 4222 and the third connection bracket 4223 may serve as components for providing a connection portion of the second shuttle 422 to the adjustment unit 430 to be described below.

The second connection bracket 4222 and the third connection bracket 4223 according to the present embodiment may extend from an outer surface of the second shuttle body 4221 in the direction parallel to the third direction. The second connection bracket 4222 and the third connection bracket 4223 may be sequentially disposed in the first direction. That is, the third connection bracket 4223 may be disposed at a position spaced a predetermined distance from the second connection bracket 4222 in the first direction. The second connection bracket 4222 and the third connection bracket 4223 may be formed of a ferromagnetic material such as iron. Specific shapes of the second connection bracket 4222 and the third connection bracket 4223 are not limited to the shapes illustrated in FIGS. 3 and 4 and various design changes are possible within the range of shapes which extend from the second shuttle body 4221 and are disposed to be spaced apart from the second shuttle body 4221 in the first direction.

The second connection bracket 4222 of the second shuttle 422 disposed adjacent to the first shuttle 421 among the plurality of second shuttles 422 may be disposed to face the first connection bracket 4213 of the first shuttle 421 in the first direction.

The third connection bracket 4223 formed in one of a pair of neighboring second shuttles 422 may be disposed to face the second connection bracket 4222 formed in the other in the first direction.

The adjustment unit 430 may be connected to the shuttle 420 and may adjust the distance between a pair of neighboring shuttles 420. That is, the adjustment unit 430 may serve as a component for changing the direction of movement of the plurality of shuttles 420 to increase or decrease the distance between a pair of neighboring shuttles 420.

The adjustment unit 430 may include a first adjustment member 431 and a second adjustment member 432.

The first adjustment member 431 may be connected to the first shuttle 421 and may move the first shuttle 421 in the first direction or in the direction opposite to the first direction.

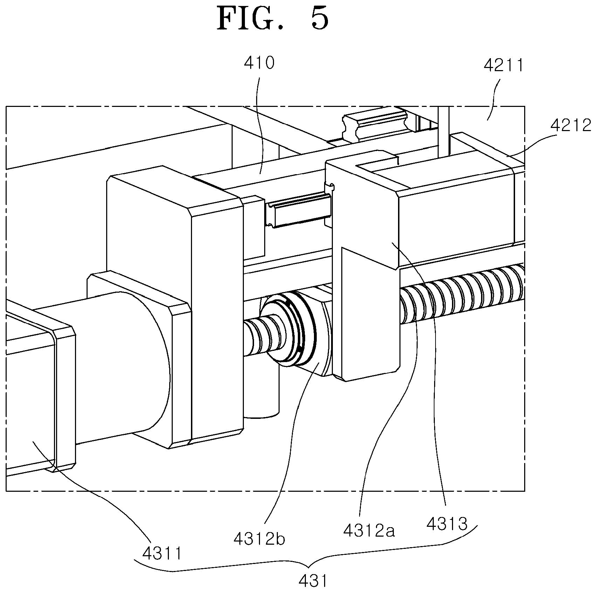

FIG. 5 is a schematic perspective view illustrating a configuration of a first adjustment member according to one embodiment of the present disclosure.

Referring to FIGS. 1 to 5, the first adjustment member 431 according to the present embodiment may include an actuator 4311, a conversion member 4312, and a transmission member 4313.

The actuator 4311 may generate a driving force for operating the first adjustment member 431. The actuator 4311 according to the present embodiment may include various types of electric motors for receiving external power and generating a rotational force. The actuator 4311 may be positionally fixed by being coupled to the rail unit 410 or a separate frame.

The conversion member 4312 may be connected to the actuator 4311 and may convert the driving force of the actuator 4311 into linear movement parallel to the first direction.

The conversion member 4312 according to the present embodiment may include a first conversion member 4312a and a second conversion member 4312b.

The first conversion member 4312a may receive the driving force from the actuator 4311 to rotate. The first conversion member 4312a according to the present embodiment may have a bolt shape in which threads are formed on an outer surface. A longitudinal direction of the first conversion member 4312a may be disposed parallel to the first direction. One end portion of the first conversion member 4312a may be connected to an output shaft of the actuator 4311. The first conversion member 4312a may rotate clockwise or counterclockwise around a central axis during the operation of the actuator 4311.

The second conversion member 4312b may be connected to the first conversion member 4312a and moved in the first direction or in the direction opposite to the first direction according to a rotational direction of the first conversion member 4312a. The second conversion member 4312b according to the present embodiment may have a nut shape in which threads are formed on an inner surface. The inner surface of the second conversion member 4312b may be engaged and coupled with the outer surface of the first conversion member 4312a. The second conversion member 4312b may be directly engaged and coupled with the first conversion member 4312a, or alternatively, may be indirectly engaged and coupled by a plurality of balls which circulate along the threads of the first conversion member 4312a and the second conversion member 4312b.

The second conversion member 4312b may linearly move in the first direction or in the direction opposite to the first direction as the first conversion member 4312a rotates clockwise or counterclockwise around the central axis.

The transmission member 4313 may be connected to the conversion member 4312 and the first shuttle 421 and may move the first shuttle 421 in conjunction with the linear movement of the conversion member 4312. The transmission member 4313 according to the present embodiment may be disposed between the second conversion member 4312b and the main bracket 4212. One end portion of the transmission member 4313 may be connected to the second conversion member 4312b. The one end portion of the transmission member 4313 may be integrally fixed to the second conversion member 4312b by welding, bolting, or the like. The other end portion of the transmission member 4313 may be connected to the main bracket 4212. The other end portion of the transmission member 4313 may be integrally fixed to the main bracket 4212 by welding, bolting, or the like.

When the second conversion member 4312b moves in the first direction, the transmission member 4313 may move in the first direction along with the second conversion member 4312b, press the main bracket 4212 in the first direction, and move the first shuttle 421 in the first direction.

When the second conversion member 4312b moves in the direction opposite to the first direction, the transmission member 4313 may move in the direction opposite to the first direction along with the second conversion member 4312b, pull the main bracket 4212 in the direction opposite to the first direction, and move the first shuttle 421 in the direction opposite to the first direction.

The second adjustment member 432 may be connected to the second shuttle 422 and may selectively allow the second shuttle 422 to move in the direction opposite to the first direction. That is, the second adjustment member 432 may serve as a component for changing the distance between the first shuttle 421 and the second shuttle 422 or the distance between neighboring second shuttles 422 by allowing or restricting the second shuttle 422 to move along with the first shuttle 421 when the first shuttle 421 moves in the direction opposite to the first direction.

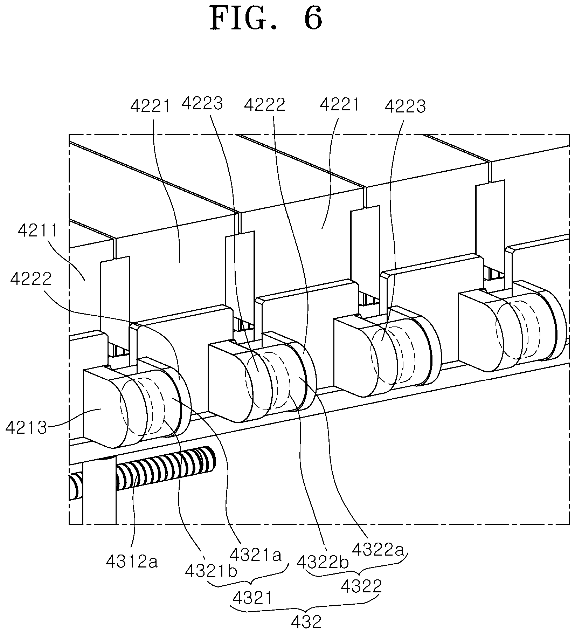

FIG. 6 is a schematic enlarged view illustrating a configuration of a second adjustment member according to one embodiment of the present disclosure.

Referring to FIG. 6, the second adjustment member 432 according to the present embodiment may include a first connection member 4321.

The first connection member 4321 may be disposed between the first shuttle 421 and the second shuttle 422. The first connection member 4321 may selectively connect the first shuttle 421 to the second shuttle 422. That is, the first connection member 4321 may serve as a component for connecting or disconnecting the first shuttle 421 to or from the second shuttle 422 by its own driving force. When the first connection member 4321 connects the first shuttle 421 to the second shuttle 422, the second shuttle 422 may move in the direction opposite to the first direction along with the first shuttle 421. When the first connection member 4321 disconnects the first shuttle 421 from the second shuttle 422, the second shuttle 422 may be positionally fixed without moving in the direction opposite to the first direction along with the first shuttle 421.

The first connection member 4321 according to the present embodiment may include a first connection body 4321a and a first electromagnet 4321b.

The first connection body 4321a may be fixed to the second shuttle 422 and disposed to face the first shuttle 421. The first connection body 4321a according to the present embodiment may be disposed between the first connection bracket 4213 and the second connection bracket 4222 of the second shuttle 422 disposed adjacent to the first shuttle 421. One end portion of the first connection body 4321a may be fixed to the second connection bracket 4222 of the second shuttle 422 disposed adjacent to the first shuttle 421. The other end portion of the first connection body 4321a may extend from the second connection bracket 4222 of the second shuttle 422 disposed adjacent to the first shuttle 421 in the direction opposite to the first direction.

The other end portion of the first connection body 4321a may come into contact with the first connection bracket 4213 of the first shuttle 421 as the first shuttle 421 moves in the first direction. Accordingly, when the first shuttle 421 moves in the first direction, the second shuttle 422 may move in the first direction along with the first shuttle 421.

The first electromagnet 4321b may be provided in the first connection body 4321a and may receive external power and generate a magnetic force. The first electromagnet 4321b according to the present embodiment may be, for example, various types of electromagnets which can generate or stop to generate a magnetic force depending on whether power is supplied. The first electromagnet 4321b may be disposed inside the first connection body 4321a. However, the first electromagnet 4321b is not limited thereto and may form part or all of an exterior of the first connection body 4321a.

The first connection body 4321a may be fixed to the first shuttle 421 by the magnetic force generated by the first electromagnet 4321b. For example, as the first electromagnet 4321b generates a magnetic force, an attractive force may be generated between the first connection bracket 4213 and the second connection bracket 4222, and the first connection body 4321a may be tightly fixed to the first connection bracket 4213 by this attractive force.

When the second shuttle 422 is provided as a plurality of second shuttles, the second adjustment member 432 may further include a second connection member 4322.

The second connection member 4322 may be disposed between a pair of neighboring second shuttles 422. The second connection member 4322 may selectively connect the pair of neighboring second shuttles 422. That is, the second connection member 4322 may serve as a component for connecting or disconnecting a pair of neighboring second shuttles 422 by its own driving force.

The second connection member 4322 may be provided as a plurality of second connection members. Each second connection member 4322 may be individually disposed between a pair of neighboring second shuttles 422.

The second connection member 4322 according to the present embodiment may include a second connection body 4322a and a second electromagnet 4322b.

The second connection body 4322a may be fixed to one of a pair of neighboring second shuttles 422. The second connection body 4322a according to the present embodiment may be disposed between the second connection bracket 4222 formed in one of the pair of neighboring second shuttles 422 and the third connection bracket 4223 formed in the other. One end portion of the second connection body 4322a may be fixed to the second connection bracket 4222 of the second shuttle 422 that is positioned relatively far from the first shuttle 421 among the pair of neighboring second shuttles 422. The other end portion of the second connection body 4322a may extend from the second connection bracket 4222 in the direction opposite to the first direction.

As the first shuttle 421 moves in the first direction, the other end portion of the second connection body 4322a may come into contact with the third connection bracket 4223 of the second shuttle 422 that is positioned relatively close to the first shuttle 421 among the pair of neighboring second shuttles 422. Accordingly, when the first shuttle 421 moves in the first direction, the plurality of second shuttles 422 may move in the first direction along with the first shuttle 421.

The second electromagnet 4322b may be provided in the second connection body 4322a and may receive external power and generate a magnetic force. The second electromagnet 4322b according to the present embodiment may be, for example, various types of electromagnets which can generate or stop to generate a magnetic force depending on whether power is supplied. The second electromagnet 4322b may be disposed inside the second connection body 4322a. However, the second electromagnet 4322b is not limited thereto and may form part or all of an exterior of the second connection body 4322a.

As the magnetic force is generated from the second electromagnet 4322b, the second connection body 4322a may be tightly fixed to the third connection bracket 4223 of the second shuttle 422 that is positioned relatively close to the first shuttle 421 among the pair of neighboring second shuttles 422.

Hereinafter, the operation of the aligning device according to one embodiment of the present disclosure will be described.

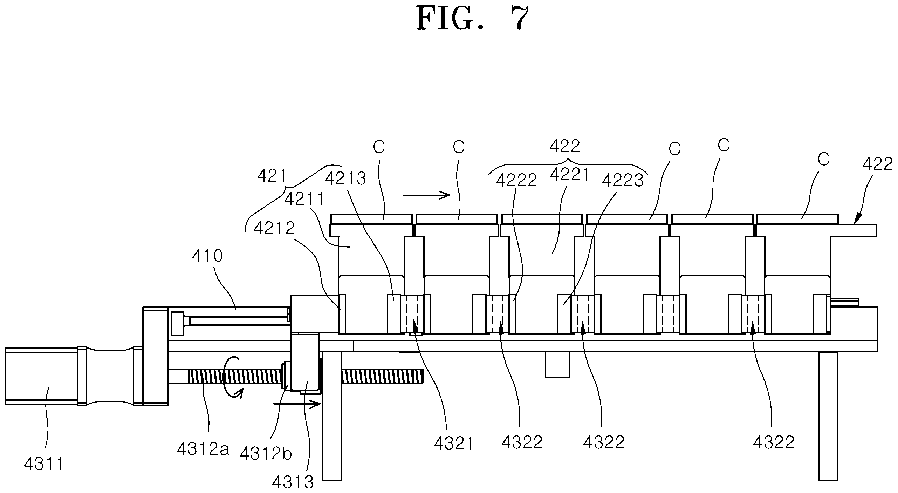

FIGS. 7 to 10 are schematic views illustrating an operation process of the aligning device according to one embodiment of the present disclosure.

Referring to FIG. 7, when the distance between a pair of solar cells C needs to be adjusted during the process of transporting the solar cell C and the wire W, the actuator 4311 generates a driving force to rotate the first conversion member 4312a in one direction.

The second conversion member 4312b is moved in the first direction by the rotation of the first conversion member 4312a, and the transmission member 4313 presses the first shuttle 421 in the first direction.

The first shuttle 421 is moved a set distance in the first direction by the pressing force transmitted from the transmission member 4313.

As the first shuttle 421 moves in the first direction, the first connection body 4321a comes into contact with the first connection bracket 4213, and the second connection body 4322a comes into contact with the third connection bracket 4223a.

Accordingly, the pressing force transmitted from the transmission member 4313 is transmitted from the first shuttle 421 to the second shuttle 422, and the plurality of second shuttles 422 move a set distance in the first direction along with the first shuttle 421.

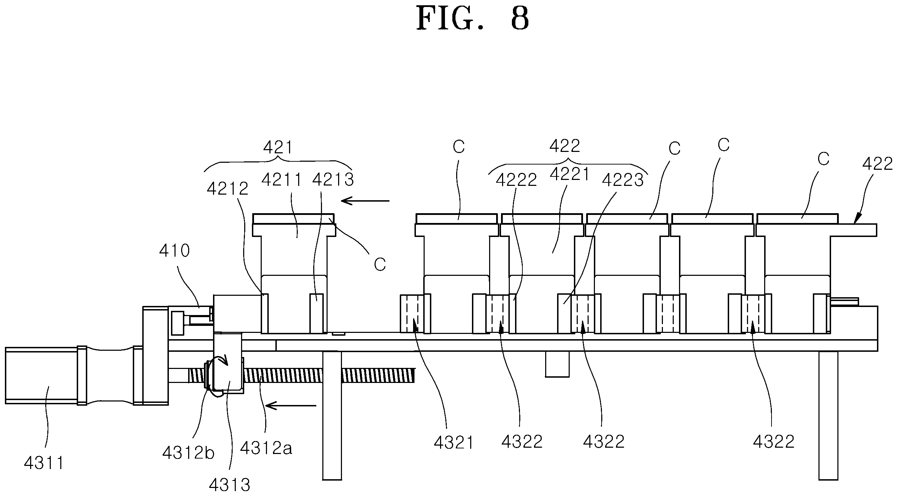

Referring to FIG. 8, to increase the distance between the solar cell C located on the first shuttle 421 and the solar cell C located on the second shuttle 422 disposed adjacent to the first shuttle 421, the power supplied to the first electromagnet 4321b is cut off, and the magnetic force generated by the first electromagnet 4321b is stopped.

Thereafter, the actuator 4311 generates a driving force to rotate the first conversion member 4312a in the other direction.

The second conversion member 4312b is moved in the direction opposite to the first direction by the rotation of the first conversion member 4312a, and the first shuttle 421 is moved in the direction opposite to the first direction along with the transmission member 4313.

As the magnetic force is not generated by the first electromagnet 4321b, the first connection body 4321a is separated from the first connection bracket 4213.

The second shuttle 422 disposed adjacent to the first shuttle 421 does not move in the direction opposite to the first direction and is fixed at a position at which the second shuttle 422 moves a set distance in the first direction from an initial position.

Accordingly, the distance between the solar cell C located on the first shuttle 421 and the solar cell C located on the second shuttle 422 disposed adjacent to the first shuttle 421 increases as much as the set distance.

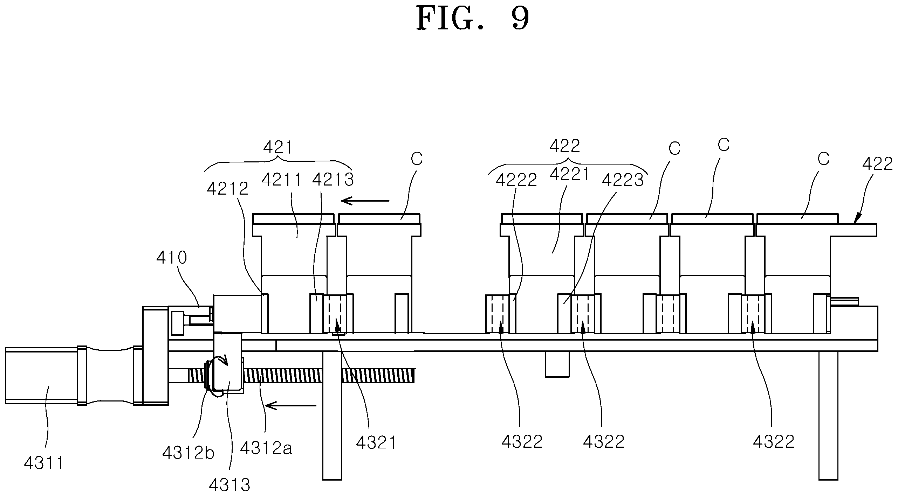

Referring to FIG. 9, to increase the distance between the solar cells C located on the pair of neighboring second shuttles 422 in the state of FIG. 7, the power supplied to the second electromagnet 4322b located between the pair of neighboring second shuttles 422 is cut off, and the magnetic force generated by the second electromagnet 4322b is stopped.

Meanwhile, the second electromagnet 4322b and the first electromagnet 4321b which are disposed in the direction opposite to the first direction from the corresponding second electromagnet 4322b receive external power and generate a magnetic force.

Thereafter, the actuator 4311 generates a driving force to rotate the first conversion member 4312a in the other direction.

The second conversion member 4312b is moved in the direction opposite to the first direction by the rotation of the first conversion member 4312a, and the first shuttle 421 is moved in the direction opposite to the first direction along with the transmission member 4313.

Among the pair of neighboring second shuttles 422, the second shuttle 422 located relatively close to the first shuttle 421 and the second shuttle 422 located in the direction opposite to the first direction from the corresponding second shuttle 422 are moved in the direction opposite to the first direction along with the first shuttle 421 by the magnetic force.

Among the pair of neighboring second shuttles 422, the second shuttle 422 located relatively far from the first shuttle 421 does not move in the direction opposite to the first direction and is fixed at a position at which the second shuttle 422 moves the set distance from the initial position in the first direction.

Accordingly, the distance between the solar cells C located on the pair of neighboring second shuttles 422 increases as much as the set distance.

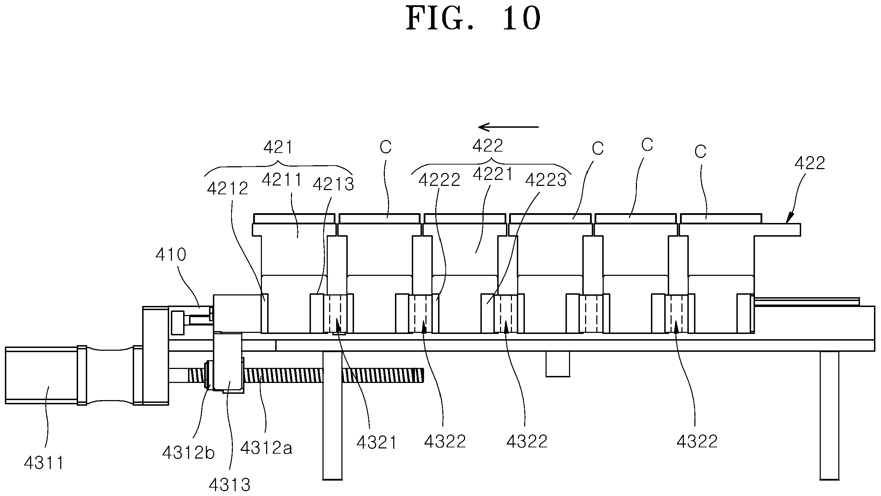

Referring to FIG. 10, since power is supplied to both the first electromagnet 4321b and the plurality of second electromagnets 4322b, the plurality of second shuttles 422 may be returned to the initial positions by the magnetic forces generated by the first electromagnet 4321b and the second electromagnet 4322b.

Hereinafter, a tabbing apparatus according to another embodiment of the present disclosure will be described.

The tabbing apparatus according to the present embodiment may differ only in the detailed configuration of the aligning device 40 from the tabbing apparatus according to one embodiment of the present disclosure.

Accordingly, in describing the tabbing apparatus according to the present embodiment, only the detailed configuration of the aligning device 40, which differs from that of the tabbing apparatus according to one embodiment of the present disclosure will be described. The description of the tabbing apparatus according to one embodiment of the present disclosure may be applied as is to the remaining components of the tabbing apparatus according to the present embodiment.

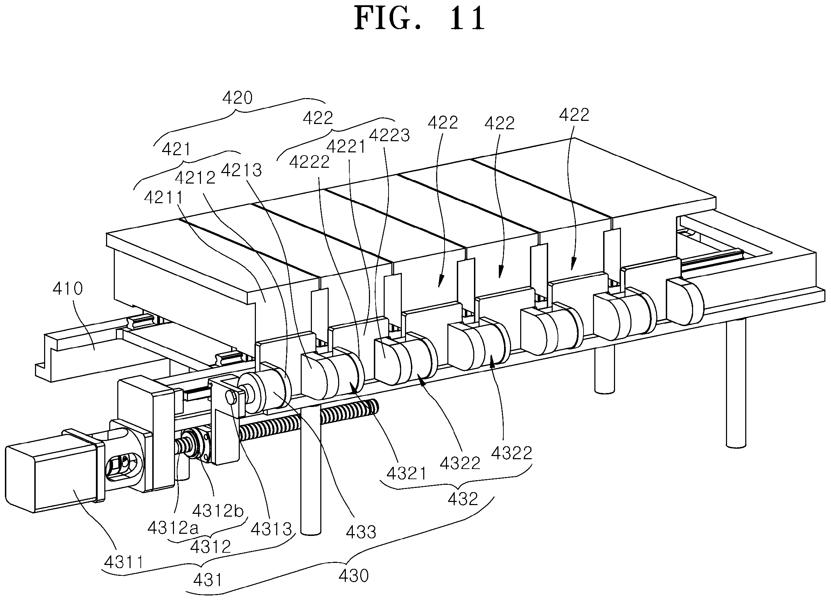

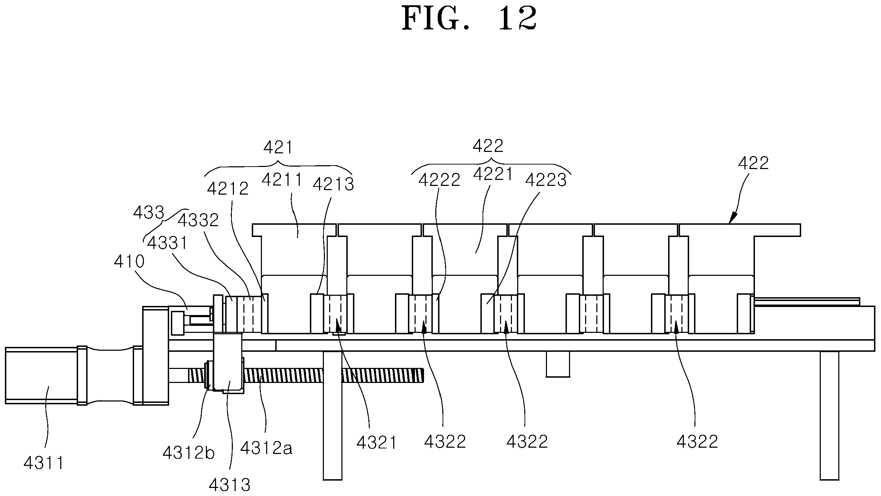

FIG. 11 is a schematic perspective view illustrating a configuration of an aligning device according to another embodiment of the present disclosure, and FIG. 12 is a schematic side view illustrating a configuration of a shuttle adjustment member according to another embodiment of the present disclosure.

Referring to FIGS. 11 and 12, the transmission member 4313 according to the present embodiment may not be directly connected to the main bracket 4212. The other end portion of the transmission member 4313 may be disposed to face the main bracket 4212 at a set distance in the direction parallel to the first direction.

The adjustment unit 430 according to the present embodiment may further include a shuttle adjustment member 433.

The shuttle adjustment member 433 may be disposed between the first shuttle 421 and the first adjustment member 431 and may selectively allow the first shuttle 421 to move in the direction opposite to the first direction. That is, the shuttle adjustment member 433 may serve as a component for connecting or disconnecting the first shuttle 421 to or from the transmission member 4313 by its own driving force.

The shuttle adjustment member 433 according to the present embodiment may include a shuttle connection body 4331 and a shuttle electromagnet 4332.

The shuttle connection body 4331 may be fixed to the first shuttle 421 and disposed to face the first adjustment member 431. The shuttle connection body 4331 according to the present embodiment may be disposed between the main bracket 4212 and the transmission member 4313. One end portion of the shuttle connection body 4331 may be fixed to the main bracket 4212. The other end portion of the shuttle connection body 4331 may extend from the main bracket 4212 in the direction opposite to the first direction.

The other end portion of the shuttle connection body 4331 may come into contact with the transmission member 4313 as the transmission member 4313 moves in the first direction. Accordingly, the first shuttle 421 may move in the first direction along with the transmission member 4313 when the transmission member 4313 moves in the first direction.

The shuttle electromagnet 4332 may be provided in the shuttle connection body 4331 and may receive external power and generate a magnetic force. The shuttle electromagnet 4332 according to the present embodiment may be, for example, various types of electromagnets which can generate or stop to generate a magnetic force depending on whether power is supplied. The shuttle electromagnet 4332 may be disposed inside the shuttle connection body 4331. However, the shuttle electromagnet 4332 is not limited thereto and may form part or all of an exterior of the shuttle connection body 4331.

The shuttle connection body 4331 may be fixed to the transmission member 4313 by the magnetic force generated by the shuttle electromagnet 4332. For example, as the shuttle electromagnet 4332 generates a magnetic force, an attractive force may be generated between the main bracket 4212 and the transmission member 4313, and the shuttle connection body 4331 may be tightly fixed to the transmission member 4313 by this attractive force.

According to the present disclosure, since the distance between neighboring solar cells can be adjusted independently of a transport operation of the solar cell and a wire, it is possible to secure the continuity of transport and bonding processes of the solar cell and the wire.

According to the present disclosure, since the number of shuttles moved in a direction opposite to a first direction is adjusted depending on whether an electromagnet generates a magnetic force, it is possible to freely change a distance adjustment position.

Although the present disclosure has been described with reference to embodiments illustrated in the drawings, the embodiments are merely illustrative, and those skilled in the art will understand that various modifications and equivalent other embodiments are possible therefrom.

Accordingly, the technical scope of the present disclosure should be determined by the appended claims.

## Claims

1. An aligning device comprising:
a rail unit;
a plurality of shuttles movably installed on the rail unit; and
an adjustment unit connected to the shuttles and configured to adjust a distance between a pair of neighboring shuttles.

2. The aligning device of claim 1, wherein the shuttles include a first shuttle and a second shuttle arranged in a first direction, and
the second shuttle moves in the first direction along with the first shuttle as the first shuttle moves in the first direction.

3. The aligning device of claim 2, wherein the adjustment unit includes:
a first adjustment member connected to the first shuttle and configured to move the first shuttle in the first direction or a direction opposite to the first direction; and
a second adjustment member connected to the second shuttle and configured to selectively allow the second shuttle to move in the direction opposite to the first direction.

4. The aligning device of claim 3, wherein the first adjustment member includes:
an actuator configured to generate a driving force;
a conversion member connected to the actuator and configured to convert the driving force of the actuator into linear movement; and
a transmission member connected to the conversion member and the first shuttle and configured to move the first shuttle in conjunction with the linear movement of the conversion member.

5. The aligning device of claim 4, wherein the conversion member includes:
a first conversion member configured to receive the driving force from the actuator to rotate; and
a second conversion member connected to the first conversion member and configured to move in the first direction or the direction opposite to the first direction according to a rotational direction of the first conversion member.

6. The aligning device of claim 5, wherein the first conversion member is disposed parallel to the first direction.

7. The aligning device of claim 3, wherein the second adjustment member includes a first connection member disposed between the first shuttle and the second shuttle and selectively connecting the first shuttle and the second shuttle.

8. The aligning device of claim 7, wherein the first connection member includes:
a first connection body fixed to the second shuttle and disposed to face the first shuttle; and
a first electromagnet provided in the first connection body and configured to receive external power and generate a magnetic force, and
the first connection body is fixed to the first shuttle by the magnetic force generated by the first electromagnet.

9. The aligning device of claim 8, wherein the first connection body extends from the second shuttle in the direction opposite to the first direction.

10. The aligning device of claim 3, wherein the second shuttle is provided as a plurality of second shuttles, and the plurality of second shuttles are arranged in the first direction.

11. The aligning device of claim 10, wherein the second adjustment member includes a second connection member disposed between a pair of neighboring second shuttles and selectively connecting the pair of neighboring second shuttles.

12. The aligning device of claim 11, wherein the second connection member includes:
a second connection body fixed to one of the pair of neighboring second shuttles; and
a second electromagnet provided in the second connection body and configured to receive external power and generate a magnetic force, and
the second connection body is fixed to the other of the pair of neighboring second shuttles by the magnetic force generated by the second electromagnet.

13. The aligning device of claim 3, wherein the adjustment unit further includes a shuttle adjustment member disposed between the first shuttle and the first adjustment member and configured to selectively allow the first shuttle to move in the direction opposite to the first direction.

14. The aligning device of claim 13, wherein the shuttle adjustment member includes:
a shuttle connection body fixed to the first shuttle and disposed to face the first adjustment member; and
a shuttle electromagnet provided in the shuttle connection body and configured to receive external power and generate a magnetic force, and
the shuttle connection body is fixed to the first adjustment member by the magnetic force generated by the shuttle electromagnet.

15. A tabbing apparatus comprising:
a transport line configured to transport a plurality of solar cells;
a bonding device configured to bond the solar cell transported by the transport line and a wire seated on the solar cell; and
an aligning device configured to adjust a distance between the plurality of solar cells transported by the transport line,
wherein the aligning device includes:
a rail unit;
a plurality of shuttles movably installed on the rail unit and selectively connected to the solar cells that are different from each other; and
an adjustment unit connected to the shuttles and configured to adjust a distance between a pair of neighboring shuttles.
